# EUROPÄISCHE PATENTSCHRIFT

(11) **EP 3 640 656 B1**
(45) Veröffentlichungstag und Bekanntmachung des Hinweises auf die Patenterteilung: **09.04.2025**
(21) Anmeldenummer: 19201069.2
(22) Anmeldetag: 02.10.2019
(51) Int. Cl.: G01R 31/364, G01R 31/374, G01R 35/00, G01K 7/16

(54) **VERFAHREN ZUM BETRIEB EINES BATTERIESENSORS UND BATTERIESENSOR**
METHOD OF OPERATING A BATTERY SENSOR AND BATTERY SENSOR
PROCÉDÉ DE FONCTIONNEMENT D'UN CAPTEUR DE BATTERIE ET CAPTEUR DE BATTERIE

(30) Priorität: 12.10.2018 DE 102018217528
(43) Veröffentlichungstag der Anmeldung: 22.04.2020
(73) Patentinhaber: Continental Automotive Technologies GmbH, 30175 Hannover (DE)
(72) Erfinder: Frenzel, Henryk - c/o Continental Teves AG & Co. OHG, 60488 Frankfurt am Main (DE); Aumer, Andreas - c/o Continental Teves AG & Co. OHG, 60488 Frankfurt am Main (DE)
(74) Vertreter: Continental Corporation

(56) Entgegenhaltungen:
- DE-A1- 102014 213 731
- US-A- 6 028 426
- US-B2- 8 029 187

## Beschreibung

Die Erfindung betrifft ein Verfahren zum Betrieb eines Batteriesensors sowie einen Batteriesensor.

Batteriesensoren werden in Fahrzeugen zur Erfassung von Batterieparameter der Fahrzeugbatterie verwendet, um Aussagen über den Ladezustand und/oder den Gesundheitszustand der Batterie treffen zu können. Der Batteriesensor ist üblicherweise an einem der Batteriepole angeordnet und weist beispielsweise eine Batterieklemme zur Kontaktierung mit der Fahrzeugbatterie auf. Die zu erfassenden Batterieparameter sind beispielsweise die Batteriespannung, der Batteriestrom und die Temperatur der Batterie.

Zur Erfassung des Batteriestroms sind beispielsweise zumindest ein im Strompfad des Laststroms angeordneter Messwiderstand sowie zumindest eine Spannungserfassungseinrichtung vorgesehen, die den Spannungsabfall eines über den Messwiderstand fließenden Stroms, beispielsweise des Laststroms, erfassen kann. Ist der elektrische Widerstand des Messwiderstandes bekannt, kann aus dem erfassten Spannungsabfall über den Messwiderstand über das ohmsche Gesetz der über den Messwiderstand fließende Strom, also beispielsweise der Laststrom, ermittelt werden.

Der elektrische Widerstand des Messwiderstandes kann sich aber über die Lebensdauer des Batteriesensors und bei einer Temperaturänderung ändern. Um die Genauigkeit des Batteriesensors zu verbessern, sind aus dem Stand der Technik Verfahren zur Ermittlung eines Korrekturwertes für den elektrischen Widerstand des Messwiderstandes und/oder des erfassten Spannungsabfalls über den Messwiderstand bekannt. Mit diesem Korrekturwert kann eine Änderung des elektrischen Widerstandes des Messwiderstandes rechnerisch kompensiert werden.

Die Temperaturermittlung des Batteriesensors erfolgt beispielsweise über einen im Batteriesensor angeordneten Temperatursensor, der mit einem Bauteil des Batteriesensors verbunden ist, das thermisch leitend mit der Batterie verbunden ist.

Beispielsweise ist der Temperatursensor auf dem Messwiderstand angeordnet. Die sichere Befestigung des Temperatursensors auf dem Messwiderstand ist aber sehr aufwändig und erfordert zusätzliche Arbeitsschritte bei der Montage des Batteriesensors.

Alternativ wird der Temperatursensor auf einer Leiterplatte, auf der sich die Spannungserfassungseinrichtung bzw. eine Auswerteschaltung befinden, angeordnet. Der Temperatursensor ist bei einer solchen Ausführungsform, beispielsweise über Kontakte, die eine sehr gute Wärmeleitfähigkeit aufweisen, mit dem Messwiderstand gekoppelt. Erwärmt sich der Messwiderstand, werden die Kontakte und somit der Temperatursensor erwärmt.

Ein solches System mit Temperatursensor ist beispielsweise in der DE 10 2014 213 731 A1 gezeigt. In der US 8029187 B2 ist ein Verfahren zur Bestimmung einer Temperatur aus der Änderung des elektrischen Widerstandes eines Temperaturmesswiderstandes gezeigt.

Unabhängig von der Position des Temperatursensors reagieren diese Systeme aufgrund der räumlichen Entfernung des Temperatursensors zur Fahrzeugbatterie relativ träge. Zudem kann mit zunehmendem Abstand des Temperatursensors zur Fahrzeugbatterie die Ungenauigkeit der Temperaturerfassung, beispielsweise aufgrund von anderen Temperatureinflüssen, steigen.

Aufgabe der Erfindung ist es, ein Verfahren zum Betrieb eines Batteriesensors sowie einen Batteriesensor bereitzustellen, die eine zuverlässige und genaue Bestimmung der Temperatur des Messwiderstandes und somit eine genauere Messung von Batterieparametern ermöglichen.

Zur Lösung der Aufgabe ist gemäß Anspruch 1 ein Verfahren zum Betrieb eines Batteriesensors vorgesehen, wobei der Batteriesensor einen ersten Anschluss und einen zweiten Anschluss zur Kontaktierung mit den Polen einer Batterie, zumindest einen Messwiderstand sowie zumindest eine Spannungserfassungseinrichtung zur Erfassung eines Spannungsabfalls eines über den Batteriesensor fließenden Laststroms der Batterie über den Messwiderstand und zur Ausgabe zumindest eines von dem erfassten Spannungsabfall abhängigen Messwertes zur Bestimmung des über den Batteriesensor fließenden Laststrom sowie eine Auswerteschaltung aufweist. Das Verfahren weist die folgenden Schritte auf:
- Ermitteln eines Korrekturwertes für den Messwert durch die Auswerteschaltung, und
- Ermitteln eines ersten Temperaturwertes des Messwiderstandes basierend auf dem ermittelten Korrekturwert durch die Auswerteschaltung.

Der elektrische Widerstand des Messwiderstandes ist unter anderem temperaturabhängig. Das heißt, eine Temperaturänderung der Batterie, die sich auch auf den thermisch mit der Batterie gekoppelten Messwiderstand auswirkt, führt zu einer Änderung des elektrischen Widerstandes des Messwiderstandes. Um diese Änderung des elektrischen Widerstandes auszugleichen, wird üblicherweise durch die Auswerteschaltung ein Korrekturwert für den elektrischen Widerstand des Messwiderstandes und/oder für den erfassten Spannungsabfall über den Messwiderstand ermittelt. Mit diesem Korrekturwert ist eine wesentlich genauere Bestimmung des über den Messwiderstand fließenden Stroms möglich, da eine Änderung des elektrischen Widerstandes des Messwiderstandes rechnerisch ausgeglichen werden kann.

Die Temperaturabhängigkeit des Korrekturwert wird anschließend zur Bestimmung der Temperatur des Messwiderstandes genutzt.

Der Zusammenhang zwischen der Temperatur und dem Korrekturwert wird vorab ermittelt und beispielswiese in einem Speicher der Auswerteschaltung abgelegt. Ist der Korrekturwert bekannt, kann aus den im Speicher abgelegten Daten der zu diesem Korrekturwert korrespondierende Temperaturwert ermittelt werden. Es ist somit kein separater Temperatursensor erforderlich. Da zudem die Temperatur des Messwiderstandes ermittelt wird, der in unmittelbarem Kontakt mit der Fahrzeugbatterie steht, erfolgt eine geringstmögliche Verzögerung bei der Temperaturermittlung sowie eine Minimierung des Einflusses von weiteren externen Faktoren auf die Temperaturerfassung. Durch das vorstehend beschriebene Verfahren wird die Änderung des elektrischen Widerstandes des Messwiderstandes bzw. der Zustand des Messwiderstandes unmittelbar zur Bestimmung der Temperatur bzw. eines Temperaturwertes verwendet.

Für die Bestimmung des Korrekturwertes sind verschiedene Verfahren bekannt. Es ist lediglich erforderlich, einen Korrekturwert für den elektrischen Widerstand des Messwiderstandes und/oder für den erfassten Spannungsabfall über den Messwiderstand zu ermitteln, und diesen mit einem vorab ermittelten Zusammenhang zwischen dem Korrekturwert und der Temperatur zu vergleichen.

Beispielsweise kann zur Bestimmung des Korrekturwertes ein Referenzstromverfahren verwendet werden, das die folgenden Schritte aufweist:
- Anlegen eines Referenzstroms mit bekannter Größe an den Messwiderstand,
- Erfassen eines durch den Referenzstrom verursachten Spannungsabfalls und/oder einer durch den Referenzstrom verursachten Änderung des Spannungsabfalls,
- Ermitteln des Korrekturwertes basierend auf dem durch den Referenzstrom verursachten Spannungsabfall und/oder der durch den Referenzstrom verursachten Änderung des Spannungsabfalls.

Der Referenzstrom wird kurzzeitig an den Messwiderstand angelegt und der Spannungsabfall bzw. die Änderung des Spannungsabfalls über den Messwiderstand aufgrund des Referenzstroms mit der Spannungserfassungseinrichtung ermittelt. Aus dem vom Referenzstrom verursachten Spannungsabfall bzw. der Änderung des Spannungsabfalls sowie dem bekannten Referenzstrom kann der tatsächliche elektrische Widerstand des Messwiderstandes ermittelt werden. Aus einem Vergleich mit dem theoretischen bzw. dem in einem Speicher abgelegten elektrischen Widerstand des Messwiderstandes kann der Korrekturwert ermittelt werden.

Dieses Verfahren hat den Vorteil, dass keine Unterbrechung der Strom- bzw. der Spannungsmessung erforderlich ist. Es ist lediglich erforderlich, dass der Spannungsabfall bzw. die Änderung des Spannungsabfalls aufgrund des Referenzstroms vom Spannungsabfall durch den Laststrom getrennt werden kann.

Zudem sind aus der Referenzstromquelle keine weiteren Bauteile, insbesondere keine zusätzlichen Sensoren, erforderlich.

Bei einem Batteriesensor, der mehrere Messwiderstände aufweist, wobei der Batteriesensor zumindest einen ersten Messwiderstand der Messwiderstände und einen in Reihe zu diesem angeordneten zweiten Messwiderstand der Messwiderstände, mit jeweils zumindest einer Spannungserfassungseinrichtung zur Erfassung eines Spannungsabfalls über den jeweiligen Messwiderstand aufweist, kann das Verfahren zusätzlich folgende Schritte aufweisen:
- Anlegen eines Referenzstroms mit bekannter Größe an einen ersten Messwiderstand,
- Erfassung der Spannungsabfälle über den ersten Messwiderstand und über dem zweiten Messwiderstand mit den Spannungserfassungseinrichtungen,
- Vergleichen der Spannungsabfälle über den ersten Messwiderstand und den zweiten Messwiderstand und ermitteln der Spannungsabfälle aufgrund eines Laststroms und des Referenzstroms.

In dieser Ausführungsform wird der Referenzstrom nur an einen der Messwiderstände angelegt. Dementsprechend erfolgt eine Änderung des Spannungsabfalls nur an diesem Messwiderstand, während der Spannungsabfall an anderen Messwiderstand nur durch den Laststrom verursacht wird. Durch Vergleich der beiden Spannungsabfälle ist es möglich, den Spannungsabfall am ersten Messwiderstand aufgrund des Referenzstroms vom Spannungsabfall aufgrund des Laststroms rechnerisch zu trennen. Dadurch ist eine genaue Bestimmung des Spannungsabfalls aufgrund des Referenzstroms möglich, sodass mit dem bekannten Referenzstrom und dem ermittelten Spannungsabfall eine genaue Bestimmung des elektrischen Widerstandes des ersten Messwiderstandes bzw. eines Korrekturwertes für den elektrischen Widerstand des ersten Messwiderstandes erfolgen kann.

Dieses Verfahren bietet insbesondere Vorteile, wenn er Laststroms stark schwankt. Durch Vergleich mit dem Spannungsabfall am zweiten Messwiderstand ist es möglich, zu beurteilen, ob eine Änderung des Spannungsabfalls am ersten Messwiderstand von einer Änderung des Laststroms oder durch das Anlegen des Referenzstroms verursacht wird, sodass eine genaue Bestimmung des Spannungsabfalls aufgrund des Referenzstroms möglich ist.

Optional kann ein zweiter Temperaturwert erfasst werden und ein
Temperaturkorrekturwert für den ersten Temperaturwert basierend auf dem zweiten Temperaturwert ermittelt werden. Der Abgleich des ersten Temperaturwertes mit dem zweiten Temperaturwert ermöglicht eine genauere Bestimmung der Temperatur. Beispielsweise kann so der Einfluss anderer Faktoren, die einen Einfluss auf den elektrischen Widerstand des Messwiderstandes haben, minimiert werden.

Des Weiteren kann das Verfahren, bei dem zwei Temperaturwerte auf die vorstehend beschriebene Weise ermittelt und miteinander verglichen werden, zur Selbstdiagnose des Batteriesensors, insbesondere der Temperaturbestimmung des Batteriesensors, verwendet werden. Hierbei kann die Bestimmung des ersten Temperaturwertes genutzt werden, um die korrekte Funktion der Erfassung des zweiten Temperaturwertes, insbesondere die korrekte Funktion eines Temperatursensors, zu prüfen. Andererseits kann, wie bereits beschrieben, der zweite Temperaturwert zur Prüfung und Korrektur des ersten Temperaturwertes genutzt werden.

Der zweite Temperaturwert wird beispielsweise mit einem Sensor, insbesondere mit einem Temperatursensor, erfasst.

Zur Lösung der Aufgabe ist des Weiteren gemäß Anspruch ein Batteriesensor zur Erfassung von Batterieparametern vorgesehen, insbesondere einer Fahrzeugbatterie, mit einen ersten Anschluss und einen zweiten Anschluss zur Kontaktierung mit den Polen einer Batterie, zumindest einem Messwiderstand, mit zumindest eine Spannungserfassungseinrichtung zur Erfassung eines Spannungsabfalls eines über den Batteriesensor fließenden Laststroms der Batterie über den Messwiderstand und zur Ausgabe zumindest eines von dem erfassten Spannungsabfall abhängigen Messwertes zur Bestimmung des über den Batteriesensor fließenden Laststrom und mit einer Auswerteschaltung, wobei die Auswerteschaltung zur Ermittlung eines Korrekturwertes für den Messwert und zur Ermittlung eines ersten Temperaturwertes des Messwiderstandes basierend auf dem ermittelten Korrekturwert, insbesondere mit einem vorhergehenden Verfahren ausgebildet ist.

Der Batteriesensor kann zur Ermittlung des Korrekturwertes zumindest eine Referenzstromeinrichtung zum Anlegen eines Referenzstroms mit bekannter Größe an den Messwiderstand aufweisen. Die Ermittlung des Korrekturwertes unter Verwendung der Referenzstromeinrichtung erfolgt beispielsweise mit dem vorstehend beschriebenen Verfahren.

Optional kann der Batteriesensor auch mehrere Messwiderstände aufweisen, wobei der Batteriesensor einen ersten Messwiderstand der Messwiderstände und einen in Reihe zu diesem angeordneten zweiten Messwiderstand der Messwiderstände, mit jeweils zumindest einer Spannungserfassungseinrichtung zur Erfassung eines Spannungsabfalls über den jeweiligen Messwiderstand aufweisen.

Der Batteriesensor kann zusätzlich einen Temperatursensor zur Ermittlung eines zweiten Temperaturwertes aufweisen, wobei die Auswerteschaltung zur Ermittlung eines Temperaturkorrekturwertes für den ersten Temperaturwert basierend auf dem zweiten Temperaturwert ausgebildet ist.

Weitere Vorteile und Merkmale finden sich in der nachfolgenden Beschreibung in Verbindung mit den beigefügten Zeichnungen. In diesen zeigen:
- Figur 1: einen erfindungsgemäßen Batteriesensor;
- Figur 2: ein Ablaufdiagramm zum Betrieb des Batteriesensors aus Figur 1;
- Figur 3: eine zweite Ausführungsform eines erfindungsgemäßen Batteriesensors; und
- Figur 4: eine dritte Ausführungsform eines erfindungsgemäßen Batteriesensors.

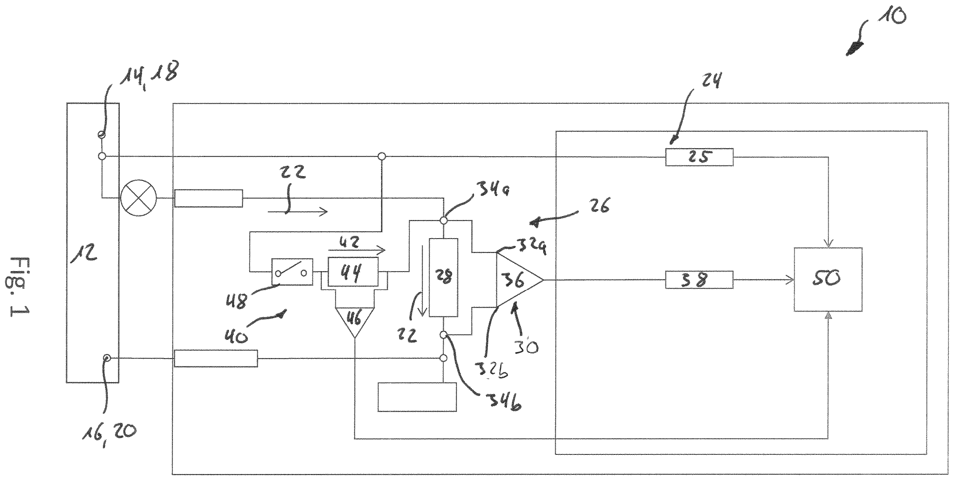

In Figur 1 ist eine schematische Darstellung eines Batteriesensors 10 für eine Batterie 12, insbesondere eine Fahrzeugbatterie, gezeigt. Der Batteriesensor 10 weist einen ersten Anschluss 14 sowie einen zweiten Anschluss 16 zur Kontaktierung mit den Polen 18, 20 der Batterie 12 auf und ist im Laststrompfad 22 des Fahrzeugs angeordnet, so dass der Laststrom 22 des Fahrzeugs durch den Batteriesensor 10 fließt.

Der Batteriesensor 10 kann in der gezeigten Ausführungsform drei Batterieparameter ermitteln, die Temperatur des Messwiderstandes, die Batteriespannung sowie den Laststrom, um Aussagen über den Ladungszustand und den Gesundheitszustand der Batterie 12 zu treffen.

Der Batteriesensor 10 hat hierzu eine Spannungsmesseinrichtung 24, die mit dem ersten Anschluss 14 kontaktiert ist, um die Batteriespannung zu erfassen. Die Spannungsmesseinrichtung 24 weist zusätzlich einen Analog-Digital-Wandler 25 zur Digitalisierung der Messsignale auf. Optional kann die Spannungsmesseinrichtung 24 auch einen Verstärker für das Messsignal aufweisen.

Des Weiteren ist eine Strommesseinrichtung 26 zur Bestimmung des Laststroms 22 vorgesehen.

Die Strommesseinrichtung 26 hat einen im Laststrompfad angeordneten Messwiderstand 28, der vom Laststrom 22 durchströmt wird, sowie eine Spannungserfassungseinrichtung 30, deren Eingänge 32a, 32b jeweils mit einem Kontaktpunkt 34a, 34b vor und nach dem Messwiderstand 28 kontaktiert sind.

Der Messwiderstand 28 besteht beispielsweise aus einem Material mit einer Wärmeabhängigkeit des elektrischen Widerstandes. Das heißt, eine Temperaturänderung des Messwiderstandes hat zumindest einen geringen Einfluss auf den elektrischen Widerstand des Messwiderstandes. Der Messwiderstand 28 kann beispielsweise aus Kupfer oder einer Kupferlegierung, bestehen.

Die Spannungserfassungseinrichtung 30 erfasst den Spannungsabfall zwischen den Kontaktpunkten 34a, 34b, also den Spannungsabfall über den Messwiderstand 28. Die Spannungserfassungseinrichtung 30 weist des Weiteren einen Verstärker 36 sowie einen Analog-Digital-Wandler 38 auf.

Bei bekanntem elektrischem Widerstand des Messwiderstandes 28 kann mit dem erfassten Spannungsabfall über den Messwiderstand 28 aus dem ohmschen Gesetz (I = U/R) der Laststrom 22 bestimmt werden.

Der elektrische Widerstand des Messwiderstandes 28 kann sich aber während des Betriebes des Batteriesensors 10 ändern. Beispielsweise kann sich der elektrische Widerstand des Materials des Messwiderstandes 28 in Abhängigkeit von der Temperatur ändern. Des Weiteren kann es zu alterungsbedingten oder umweltbedingten Änderungen des elektrischen Widerstandes des Messwiderstandes 28 kommen.

Es ist daher erforderlich, im Betrieb des Batteriesensors 10 einen Korrekturwert für den mit der Spannungserfassungseinrichtung 26 erfassten Spannungsabfall zu ermitteln.

Zu diesem Zweck ist eine Referenzstromeinrichtung 40 vorgesehen, über die ein Referenzstrom 42 mit bekannter Größe bereitgestellt werden kann. Die Referenzstromeinrichtung 40 weist einen Referenzstromwiderstand 44, eine Spannungserfassungseinrichtung 46 sowie einen Schalter 48 auf. Der Referenzstromwiderstand 44 ist ein hochgenauer Widerstand, vorzugsweise aus einem Material, das eine geringe Temperaturabhängigkeit aufweist. Die Referenzstromeinrichtung 40 ist mit dem ersten Kontaktpunkt 34a verbunden, sodass durch Schließen des Schalters 48 der Referenzstrom 42 in den ersten Kontaktpunkt 34a eingespeist und somit an den Messwiderstand 28 angelegt werden kann. Mit der Spannungserfassungseinrichtung 46 kann der Spannungsabfall am Referenzstromwiderstand 44 ermittelt werden. Mit diesem Spannungsabfall und dem bekannten elektrischen Widerstand des Referenzstromwiderstandes 44 kann der Referenzstrom sehr genau bestimmt werden.

Zur Ermittlung eines Korrekturwertes wird mit der Referenzstromeinrichtung 40 kurzzeitig ein Referenzstrom 42 mit bekannter Größe an den Messwiderstand 28 angelegt. Die Änderung des Spannungsabfalls aufgrund des zusätzlich zum Laststrom 22 angelegten Referenzstroms 42 kann mit der Spannungserfassungseinrichtung 26 ermittelt und daraus der genaue elektrische Widerstand des Messwiderstandes 28 bzw. ein Korrekturwert für den erfassten Spannungsabfall ermittelt werden. Wird anschließend durch Öffnen des Schalters 48 die Referenzstromeinrichtung 40 vom Messwiderstand 28 getrennt, kann der im Folgenden erfasste Spannungsabfall mit dem ermittelten Korrekturwert korrigiert werden.

Die erfassten Werte der Spannungsmesseinrichtung 24 sowie der Strommesseinrichtung 26 werden in einer Auswerteschaltung 50 ausgewertet, um Aussagen über den Ladungszustand und den Gesundheitszustand der Batterie 12 treffen zu können.

Um den Zustand der Batterie 12 vollständig beurteilen zu können, ist zusätzlich die Erfassung der Batterietemperatur erforderlich. Im Stand der Technik erfolgt dies üblicherweise über einen Temperatursensor, der beispielsweise auf dem Messwiderstand 28 oder einer Leiterplatte angeordnet ist.

In dem in Figur 1 gezeigten Batteriesensor 10 erfolgt die Temperaturermittlung stattdessen aus dem erfassten Spannungsabfall über den Messwiderstand 28.

Wie bereits erläutert, ist der elektrische Widerstand des Messwiderstandes 28 temperaturabhängig. Der Zusammenhang zwischen der Temperatur und dem elektrischen Widerstand des Messwiderstandes 28 wird vorab ermittelt und in der Auswertungsschaltung 50 gespeichert. Für einen ermittelten korrigierten elektrischen Widerstand des Messwiderstandes 28 bzw. für einen ermittelten Korrekturwert kann somit die Temperatur des Messwiderstandes 28 aus dem vorab ermittelten Zusammenhang bestimmt werden.

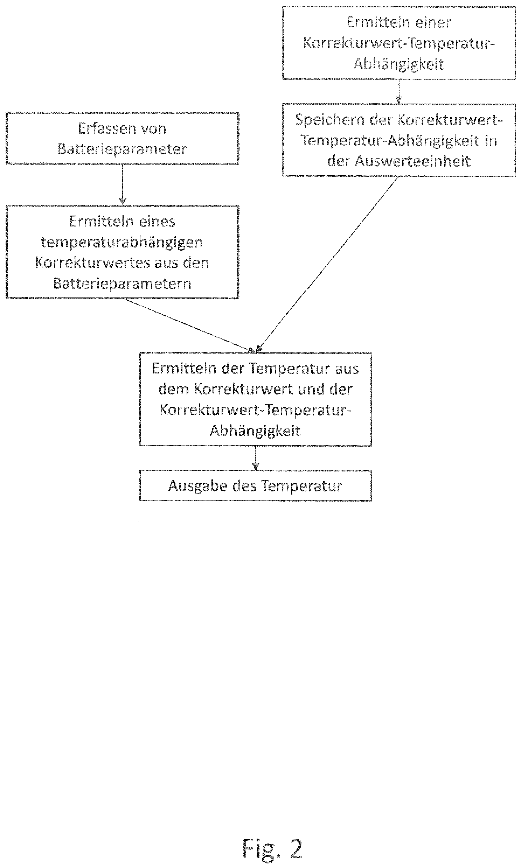

Zur Ermittlung der Temperatur wird also ein Korrekturwert für den von der Spannungserfassungseinrichtung 26 erfassten Spannungsabfall bestimmt. Anschließend wird aus diesem Korrekturwert bzw. dem mit diesem Korrekturwert ermittelten korrigierten elektrischen Widerstand des Messwiderstandes 28 und dem vorab ermittelten Zusammenhang zwischen dem elektrischen Widerstand des Messwiderstandes 28 und der Temperatur die aktuelle Temperatur des Messwiderstandes 28 bestimmt. Diese Temperatur kann, da der Messwiderstand elektrisch und thermisch leitend mit dem Batteriepol verbunden ist, zur Bestimmung der Batterietemperatur verwendet werden (Figur 2).

Es ist somit zur Bestimmung der Temperatur kein zusätzlicher Temperatursensor erforderlich. Somit muss auch kein Signal des Temperatursensors der Auswerteschaltung 50 verarbeitet werden. Es ist lediglich erforderlich, einen Korrekturwert für den elektrischen Widerstand des Messwiderstandes 28 bzw. den korrigierten elektrischen Widerstand des Messwiderstandes 28 zu bestimmen. In der hier gezeigten Ausführungsform erfolgt dies durch Anlegen eines Referenzstroms 42 mit bekannter Größe. Grundsätzlich kann aber jedes geeignete Verfahren verwendet werden, das geeignet ist, um einen Korrekturwert für den elektrischen Widerstand des Messwiderstandes 28 bzw. den korrigierten elektrischen Widerstand des Messwiderstandes 28 zu bestimmen.

Der Batteriesensor 10 kann beispielsweise auch mehrere Messwiderstände 28 aufweisen, die parallel oder in Reihe angeordnet sein können, wobei auch mehrere Spannungserfassungseinrichtungen 26 zur Erfassung der einzelnen Spannungsabfälle über die Messwiderstände 28 vorgesehen sein können. Der Referenzstrom kann in einer solchen Ausführungsform beispielsweise nur durch einzelne der Messwiderstände 28 geleitet werden, um die Spannungsabfälle aufgrund des Referenzstroms und des Laststroms besser voneinander unterscheiden bzw. trennen zu können.

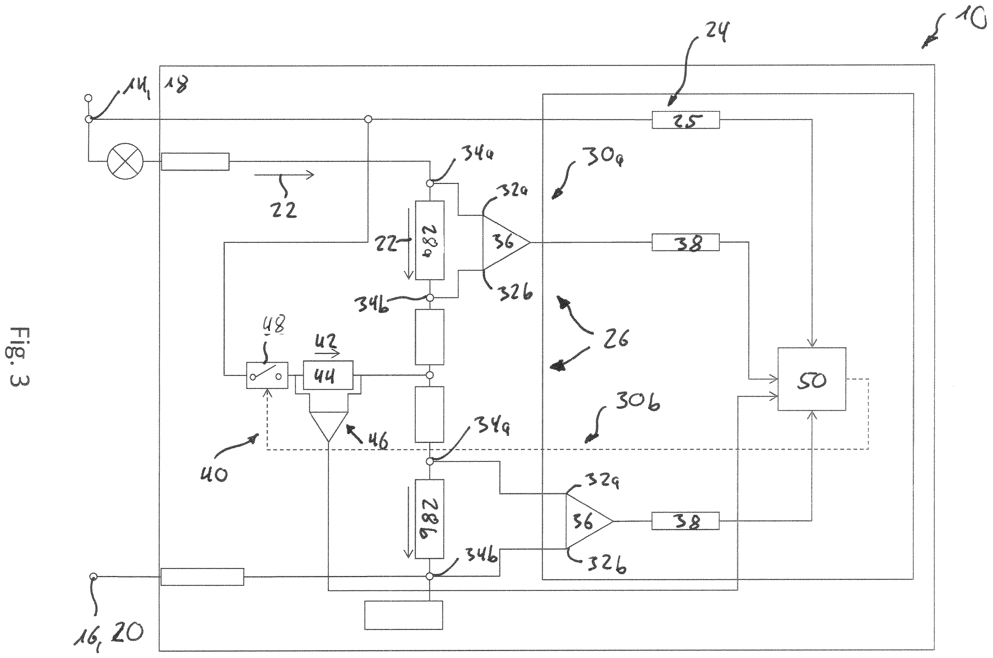

In Figur 3 ist beispielsweise eine Ausführungsform mit zwei in Reihe angeordneten Messwiderständen 28a, 28b gezeigt. Der Referenzstrom 42 wird in dieser Ausführungsform zwischen den beiden in Reihe angeordneten Messwiderständen 28a, 28b eingespeist, also gewissermaßen nur an einen der beiden Messwiderstände 28a angelegt. Wird der Referenzstrom 42 angelegt, erfolgt somit nur eine Änderung des Spannungsabfalls über den Messwiderstand 28a, während der Spannungsabfall am zweiten Messwiderstand 28b allein durch den Laststrom verursacht wird. Durch einen Vergleich der beiden Spannungsabfälle bzw. der zeitlichen Verläufe der beiden Spannungsabfälle kann der durch den Referenzstrom 42 am ersten Messwiderstand 28a hervorgerufene Spannungsabfall herausgefiltert werden.

Dieses Verfahren ist besonders vorteilhaft, wenn der Laststrom stark schwankt, so dass eine Unterscheidung, ob eine Änderung des Spannungsabfalls allein durch den Referenzstrom 42 verursacht wird oder durch eine Änderung des Laststroms schwierig ist. Eine Änderung des Laststroms 22 führt zu einer Änderung des Spannungsabfalls an beiden Messwiderständen 28a, 28b, während eine durch den Referenzstrom 42 hervorgerufene Änderung des Spannungsabfalls sich nur auf den ersten Messwiderstand 28a auswirkt.

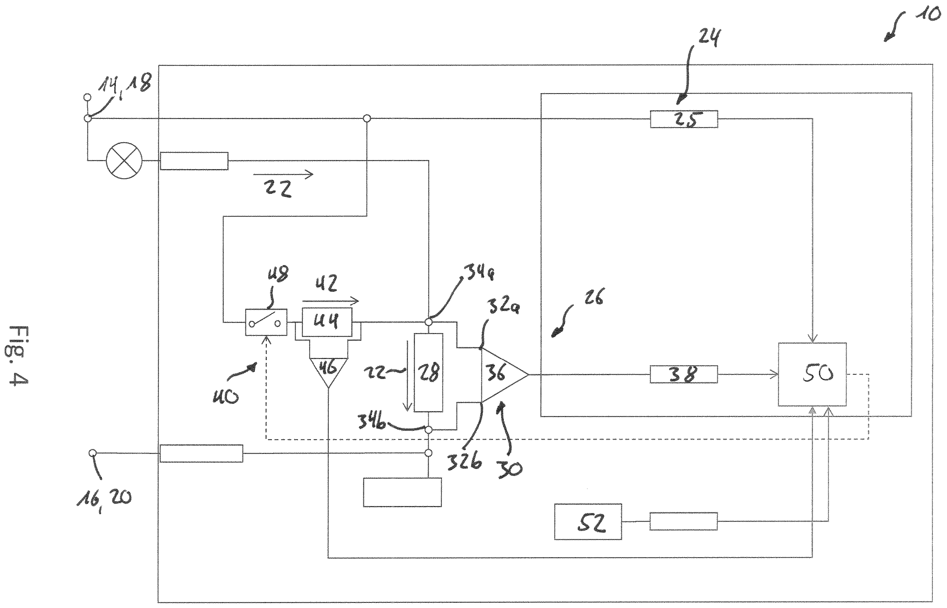

Der in Figur 4 gezeigte Batteriesensor 10 entspricht im Wesentlichen dem in Figur 1 gezeigten Batteriesensor 10. Zusätzlich weist dieser Batteriesensor einen Temperatursensor 52 auf, der mit der Auswerteschaltung 50 verbunden ist. Der Temperatursensor ist im Batteriesensor, beispielsweise auf der Leiterplatte, auf der die Auswerteschaltung 50 angeordnet ist, oder auf dem Messwiderstand 28 angeordnet. Der Temperatursensor 52 kann einen zweiten Temperaturwert an die Auswerteschaltung ausgeben.

Die gleichzeitige Erfassung eines ersten und eines zweiten Temperaturwertes kann beispielsweise zur Verbesserung der Genauigkeit der Temperaturbestimmung verwendet werden. Der zweite Temperaturwert kann beispielsweise zur Ermittlung eines Korrekturwertes für den ersten Temperaturwert verwendet werden, um beispielsweise Alterungseffekte zu kompensieren.

Alternativ kann der erste Temperaturwert genutzt werden, um den mit dem Temperatursensor 52 ermittelten zweiten Temperaturwert einer Plausibilitätsprüfung zu unterziehen. Bei einer definierten Abweichung zwischen dem ersten und dem zweiten Temperaturwert kann beispielsweise ein Fehlersignal ausgegeben werden und/oder es wird ein Korrekturwert für den zweiten Temperaturwert ermittelt.

## Patentansprüche

1. Verfahren zum Betrieb eines Batteriesensors (10), wobei der Batteriesensor (10) einen ersten Anschluss (14) und einen zweiten Anschluss (16) zur Kontaktierung mit den Polen (18, 20) einer Batterie (12), zumindest einen Messwiderstand (28, 28a, 28b) sowie zumindest eine Spannungserfassungseinrichtung (30, 30a, 30b) zur Erfassung eines Spannungsabfalls eines über den Batteriesensor (10) fließenden Laststroms (22) der Batterie (12) über den Messwiderstand (28, 28a, 28b) und zur Ausgabe zumindest eines von dem erfassten Spannungsabfall abhängigen Messwertes zur Bestimmung des über den Batteriesensor (10) fließenden Laststrom (22) sowie eine Auswerteschaltung (50) aufweist, mit folgenden Schritten:
- Ermitteln eines Korrekturwertes für den Messwert durch die Auswerteschaltung (50), und
- Ermitteln eines ersten Temperaturwertes des Messwiderstandes (28, 28a, 28b) basierend auf dem ermittelten Korrekturwert durch die Auswerteschaltung (50).

2. Verfahren nach Anspruch 1, mit folgenden Schritten:
- Anlegen eines Referenzstroms mit bekannter Größe an den Messwiderstand (28, 28a, 28b),
- Erfassen eines durch den Referenzstrom verursachten Spannungsabfalls und/oder einer durch den Referenzstrom verursachten Änderung des Spannungsabfalls,
- Ermitteln des Temperaturwertes basierend auf dem durch den Referenzstrom verursachten Spannungsabfall und/oder der durch den Referenzstrom verursachten Änderung des Spannungsabfalls.

3. Verfahren nach Anspruch 2, wobei der Batteriesensor (10) mehrere Messwiderstände (28, 28a, 28b) aufweist, wobei der Batteriesensor zumindest einen ersten Messwiderstand (28a) der Messwiderstände (28a) und einen in Reihe zu diesem angeordneten zweiten Messwiderstand (28b) der Messwiderstände (28), mit jeweils zumindest einer Spannungserfassungseinrichtung zur Erfassung eines Spannungsabfalls über den jeweiligen Messwiderstand (28a, 28b) aufweist, mit folgenden Schritten:
- Anlegen eines Referenzstroms mit bekannter Größe an den ersten Messwiderstand (28a),
- Erfassung der Spannungsabfälle über dem ersten Messwiderstand und über dem zweiten Messwiderstand mit den Spannungserfassungseinrichtungen,
- vergleichen der Spannungsabfälle über den ersten Messwiderstand (28a) und den zweiten Messwiderstand (28b) und ermitteln der Spannungsabfälle aufgrund des Laststroms und des Referenzstroms.

4. Verfahren nach einem der vorhergehenden Ansprüche, mit folgenden Schritten:
- Erfassen eines zweiten Temperaturwertes,
- Ermitteln eines Temperaturkorrekturwertes für den ersten Temperaturwert basierend auf dem zweiten Temperaturwert.

5. Verfahren nach Anspruch 4, **dadurch gekennzeichnet, dass** der zweite Temperaturwert mit einem Sensor, insbesondere mit einem Temperatursensor (52), erfasst wird.

6. Batteriesensor (10) zur Erfassung einer Spannung einer Batterie (12), insbesondere einer Fahrzeugbatterie, mit einem ersten Anschluss (14) und einem zweiten Anschluss (16) zur Kontaktierung mit den Polen (18, 20) einer Batterie (12), zumindest einem Messwiderstand (28, 28a, 28b), mit zumindest einer Spannungserfassungseinrichtung (30, 30a, 30b) zur Erfassung eines Spannungsabfalls eines über den Batteriesensor (10) fließenden Laststroms (22) der Batterie(12) über den Messwiderstand (28, 28a, 28b) und zur Ausgabe zumindest eines von dem erfassten Spannungsabfall abhängigen Messwertes zur Bestimmung des über den Batteriesensor (10) fließenden Laststrom (22), und mit einer Auswerteschaltung (50), wobei die Auswerteschaltung (50) zur Ermittlung eines Korrekturwertes für den Messwert und zur Ermittlung eines ersten Temperaturwertes des Messwiderstandes (28, 28a, 28b) basierend auf dem ermittelten Korrekturwert, insbesondere mit einem Verfahren nach einem der vorhergehenden Ansprüche, ausgebildet ist.

7. Batteriesensor nach Anspruch 6, **dadurch gekennzeichnet, dass** der Batteriesensor (10) zumindest eine Referenzstromeinrichtung (40) zum Anlegen eines Referenzstroms mit bekannter Größe an zumindest einen Messwiderstand (28, 28a, 28b) aufweist.

8. Batteriesensor nach einem der Ansprüche 6 und 7, **dadurch gekennzeichnet, dass** der Batteriesensor (10) mehrere Messwiderstände (28, 28a, 28b) aufweist, wobei der Batteriesensor (10) zumindest einen ersten Messwiderstand (28a) der Messwiderstände (28) und einen in Reihe zu diesem angeordneten zweiten Messwiderstand (28b) der Messwiderstände (28), mit jeweils zumindest einer Spannungserfassungseinrichtung (30a, 30b) zur Erfassung eines Spannungsabfalls über den jeweiligen Messwiderstand (28a, 28b) aufweist.

9. Batteriesensor nach einem der Ansprüche 6 bis 8, **dadurch gekennzeichnet, dass** der Batteriesensor (10) einen Temperatursensor (52) zur Ermittlung eines zweiten Temperaturwertes aufweist, wobei die Auswerteschaltung (50) zur Ermittlung eines Temperaturkorrekturwertes für den ersten Temperaturwert basierend auf dem zweiten Temperaturwert ausgebildet ist.

## Claims

1. Method for operating a battery sensor (10), wherein the battery sensor (10) has a first connection (14) and a second connection (16) for contact-connecting the poles (18, 20) of a battery (12), at least one measuring resistor (28, 28a, 28b) and at least one voltage capture device (30, 30a, 30b) for capturing a voltage drop of a load current (22) of the battery (12) flowing via the battery sensor (10) across the measuring resistor (28, 28a, 28b) and for outputting at least one measured value dependent on the captured voltage drop for determining the load current (22) flowing via the battery sensor (10), and an evaluation circuit (50), having the following steps of:
- determining a correction value for the measured value by means of the evaluation circuit (50), and
- determining a first temperature value of the measuring resistor (28, 28a, 28b) on the basis of the determined correction value by means of the evaluation circuit (50).

2. Method according to Claim 1, having the following steps of:
- applying a reference current of known magnitude to the measuring resistor (28, 28a, 28b),
- capturing a voltage drop caused by the reference current and/or a change in the voltage drop caused by the reference current,
- determining the temperature value on the basis of the voltage drop caused by the reference current and/or the change in the voltage drop caused by the reference current.

3. Method according to Claim 2, wherein the battery sensor (10) has multiple measuring resistors (28, 28a, 28b), wherein the battery sensor has at least one first measuring resistor (28a) of the measuring resistors (28a) and one second measuring resistor (28b) of the measuring resistors (28) which is arranged in series with the latter, each with at least one voltage capture device for capturing a voltage drop across the respective measuring resistor (28a, 28b), having the following steps of:
- applying a reference current of known magnitude to the first measuring resistor (28a),
- capturing the voltage drops across the first measuring resistor and across the second measuring resistor using the voltage capture devices,
- comparing the voltage drops across the first measuring resistor (28a) and across the second measuring resistor (28b) and determining the voltage drops on account of the load current and the reference current.

4. Method according to one of the preceding claims, having the following steps of:
- capturing a second temperature value,
- determining a temperature correction value for the first temperature value on the basis of the second temperature value.

5. Method according to Claim 4, **characterized in that** the second temperature value is captured using a sensor, in particular using a temperature sensor (52).

6. Battery sensor (10) for capturing a voltage of a battery (12), in particular a vehicle battery, having a first connection (14) and a second connection (16) for contact-connection to the poles (18, 20) of a battery (12), at least one measuring resistor (28, 28a, 28b), having at least one voltage capture device (30, 30a, 30b) for capturing a voltage drop of a load current (22) of the battery (12) flowing via the battery sensor (10) across the measuring resistor (28, 28a, 28b) and for outputting at least one measured value dependent on the captured voltage drop for determining the load current (22) flowing via the battery sensor (10), and having an evaluation circuit (50), wherein the evaluation circuit (50) is designed to determine a correction value for the measured value and to determine a first temperature value of the measuring resistor (28, 28a, 28b) on the basis of the determined correction value, in particular using a method according to one of the preceding claims.

7. Battery sensor according to Claim 6, **characterized in that** the battery sensor (10) has at least one reference current device (40) for applying a reference current of known magnitude to at least one measuring resistor (28, 28a, 28b).

8. Battery sensor according to one of Claims 6 and 7, **characterized in that** the battery sensor (10) has multiple measuring resistors (28, 28a, 28b), wherein the battery sensor (10) has at least one first measuring resistor (28a) of the measuring resistors (28) and one second measuring resistor (28b) of the measuring resistors (28) which is arranged in series with the latter, each with at least one voltage capture device (30a, 30b) for capturing a voltage drop across the respective measuring resistor (28a, 28b).

9. Battery sensor according to one of Claims 6 to 8, wherein the battery sensor (10) has a temperature sensor (52) for determining a second temperature value, wherein the evaluation circuit (50) is designed to determine a temperature correction value for the first temperature value on the basis of the second temperature value.

## Revendications

1. Procédé de fonctionnement d'un capteur de batterie (10), le capteur de batterie (10) comprenant une première connexion (14) et une seconde connexion (16) pour établir un contact avec les pôles (18, 20) d'une batterie (12), au moins une résistance de mesure (28, 28a, 28b) ainsi qu'au moins un dispositif de détection de tension (30, 30a, 30b) pour détecter une chute de tension d'un courant de charge (22) de la batterie (12) passant par le capteur de batterie (10) aux bornes de la résistance de mesure (28, 28a, 28b) et pour fournir en sortie au moins une valeur de mesure dépendant de la chute de tension détectée pour déterminer le courant de charge (22) passant par le capteur de batterie (10) et un circuit d'évaluation (50), comprenant les étapes suivantes :
- détermination par le circuit d'évaluation (50) d'une valeur de correction pour la valeur de mesure, et
- détermination par le circuit d'évaluation (50) d'une première valeur de température de la résistance de mesure (28, 28a, 28b) sur la base de la valeur de correction déterminée.

2. Procédé selon la revendication 1, comprenant les étapes suivantes :
- application à la résistance de mesure (28, 28a, 28b) d'un courant de référence de valeur connue,
- détection d'une chute de tension provoquée par le courant de référence et/ou d'une variation de la chute de tension provoquée par le courant de référence,
- détermination de la valeur de température sur la base de la chute de tension provoquée par le courant de référence et/ou sur la base de la variation de la chute de tension provoquée par le courant de référence.

3. Procédé selon la revendication 2, dans lequel le capteur de batterie (10) comprend une pluralité de résistances de mesure (28, 28a, 28b), le capteur de batterie comprenant au moins une première résistance de mesure (28a), parmi les résistances de mesure (28a) et, disposée en série avec celle-ci, une seconde résistance de mesure (28b), parmi les résistances de mesure (28), comprenant respectivement au moins un dispositif de détection de tension pour détecter une chute de tension aux bornes de la résistance de mesure (28a, 28b) respective, comprenant les étapes suivantes :
- application à la résistance de mesure (28a) d'un courant de référence de valeur connue,
- détection par les dispositifs de détection de tension des chutes de tension aux bornes de la première résistance de mesure et aux bornes de la seconde résistance de mesure,
- comparaison des chutes de tension aux bornes de la première résistance de mesure (28a) et de la seconde résistance de mesure (28b) et détermination des chutes de tension sur la base du courant de charge et du courant de référence.

4. Procédé selon l'une quelconque des revendications précédentes, comprenant les étapes suivantes :
- détection d'une seconde valeur de température,
- détermination d'une valeur de correction de température pour la première valeur de température sur la base de la seconde valeur de température.

5. Procédé selon la revendication 4, **caractérisé en ce que** la seconde valeur de température est détectée au moyen d'un capteur, notamment au moyen d'un capteur de température (52).

6. Capteur de batterie (10) destiné à détecter une tension d'une batterie (12), notamment d'une batterie de véhicule, comprenant une première connexion (14) et une seconde connexion (16) pour établir un contact avec les pôles (18, 20) d'une batterie (12), au moins une résistance de mesure (28, 28a, 28b), au moins un dispositif de détection de tension (30, 30a, 30b) pour détecter une chute de tension d'un courant de charge (22) de la batterie (12) passant par le capteur de batterie (10) aux bornes de la résistance de mesure (28, 28a, 28b) et pour fournir en sortie au moins une valeur de mesure dépendant de la chute de tension détectée pour déterminer le courant de charge (22) passant par le capteur de batterie (10), et comprenant un circuit d'évaluation (50), le circuit d'évaluation (50) étant conçu pour déterminer une valeur de correction pour la valeur de mesure et pour déterminer une première valeur de température de la résistance de mesure (28, 28a, 28b) sur la base de la valeur de correction déterminée, notamment par un procédé selon l'une quelconque des revendications précédentes.

7. Capteur de batterie selon la revendication 6, **caractérisé en ce que** le capteur de batterie (10) comprend au moins un dispositif à courant de référence (40) destiné à appliquer un courant de référence de valeur connue à au moins une résistance de mesure (28, 28a, 28b).

8. Capteur de batterie selon l'une quelconque des revendications 6 et 7, **caractérisé en ce que** le capteur de batterie (10) comprend une pluralité de résistances de mesure (28, 28a, 28b), le capteur de batterie (10) comprenant au moins une première résistance de mesure (28a), parmi les résistances de mesure (28) et, disposée en série avec celle-ci, une seconde résistance de mesure (28b), parmi les résistances de mesure (28), comprenant respectivement au moins un dispositif de détection de tension (30a, 30b) pour détecter une chute de tension aux bornes de la résistance de mesure (28a, 28b) respective.

9. Capteur de batterie selon l'une quelconque des revendications 6 à 8, **caractérisé en ce que** le capteur de batterie (10) comprend un capteur de température (52) destiné à déterminer une seconde valeur de température, le circuit d'évaluation (50) étant conçu pour déterminer une valeur de correction de température pour la première valeur de température sur la base de la seconde valeur de température.
